# EUROPÄISCHE PATENTSCHRIFT

(11) **EP 3 702 132 B1**
(45) Veröffentlichungstag und Bekanntmachung des Hinweises auf die Patenterteilung: **11.01.2023**
(21) Anmeldenummer: 19450004.7
(22) Anmeldetag: 26.02.2019
(51) Int. Cl.: B29C 64/124, B33Y 10/00

(54) **VERFAHREN ZUR LITHOGRAPHIEBASIERTEN GENERATIVEN FERTIGUNG EINES DREIDIMENSIONALEN BAUTEILS**
METHOD FOR LITHOGRAPHY-BASED GENERATIVE PRODUCTION OF A THREE-DIMENSIONAL COMPONENT
PROCÉDÉ DE FABRICATION GÉNÉRATIVE PAR LITHOGRAPHIE DE COMPOSANTS TRIDIMENSIONNELS

(43) Veröffentlichungstag der Anmeldung: 02.09.2020
(73) Patentinhaber: UpNano GmbH, 1030 Wien (AT)
(72) Erfinder: Gruber, Peter, 1140 Wien (AT)
(74) Vertreter: Keschmann, Marc

(56) Entgegenhaltungen:
- EP-A1- 3 093 123
- DE-A1-102017 110 241

## Beschreibung

Die Erfindung betrifft ein Verfahren zur lithographiebasierten generativen Fertigung eines dreidimensionalen Bauteils, bei dem von einer Bestrahlungseinrichtung ausgesendete elektromagnetische Strahlung nacheinander auf Fokuspunkte innerhalb eines Materials fokussiert wird, wodurch jeweils ein am Fokuspunkt befindliches Volumenelement des Materials mittels Multiphotonenabsorption verfestigt wird, wobei in einem Schreibbereich der Bestrahlungseinrichtung aus den Volumenelementen jeweils eine Teilstruktur aufgebaut wird und eine Mehrzahl von Teilstrukturen nebeneinander angeordnet wird.

Ein Verfahren zur Ausbildung eines Formkörpers, bei dem die Verfestigung eines flüssigen photosensitiven Materials mittels Multiphotonenabsorption vorgenommen wird, ist beispielsweise aus der DE 10111422 A1 bekannt geworden. Dazu strahlt man mit einem fokussierten Laserstrahl in das Bad des photosensitiven Materials ein, wobei die Bestrahlungsbedingungen für einen die Verfestigung auslösenden Mehrphotonenabsorptionsprozess nur in unmittelbarer Umgebung des Fokus erfüllt sind, sodass man den Fokus des Strahls nach Maßgabe der Geometriedaten des herzustellenden Formkörpers innerhalb des Badvolumens zu den zu verfestigenden Stellen führt. Die Bestrahlung des Materialbades erfolgt bei dem Verfahren gemäß der DE 10111422 A1 von oben, wobei die Strahlungsintensität so gewählt wird, dass die Flüssigkeit für die verwendete Strahlung oberhalb des Fokuspunktes im Wesentlichen transparent ist, sodass ein direktes Polymerisieren des Badmaterials ortsselektiv innerhalb des Badvolumens, d.h. auch weit unterhalb der Badoberfläche stattfindet. Bestrahlungseinrichtungen für Multiphotonen-Absorptionsverfahren umfassen eine Optik zum Fokussieren eines Laserstrahls sowie eine Ablenkeinrichtung zum Ablenken des Laserstrahls. Konstruktionsbedingt weisen solche Bestrahlungseinrichtungen einen begrenzten Schreibbereich auf, innerhalb dessen die Ablenkeinrichtung den Lasterstrahl bewegt. Der vorgegebene Schreibbereich ist in der Regel kleiner als das für das herzustellende Bauteil erforderliche Volumen. Das Bauteil muss daher in eine Mehrzahl von Teilstrukturen aufgeteilt werden, die jeweils einem Schreibbereich entsprechen und nacheinander aufgebaut werden. Nach dem Aufbau einer Teilstruktur wird die Bestrahlungseinrichtung für den Aufbau der nächsten Teilstruktur relativ zum Material verlagert und der nächste Teilbereich wird unmittelbar an den vorangehenden Teilbereich geschrieben. Dieses sog. "stitching" kann im Stoßbereich zwischen zwei aneinandergrenzenden Teilstrukturen eine Unstetigkeit verursachen, welche eine mechanische Schwachstelle des Bauteils bildet.

Bei der Anwendung von Multiphotonen-Absorptionsverfahren besteht ein weiteres Problem darin, dass bereits gebildete verfestigte Strukturen nachfolgend zu strukturierende Bereiche verschatten. Dies bedeutet, dass die für die Verfestigung ins Material eingebrachte Strahlung in bestimmten Fällen bereits verfestigte Strukturbereiche durchdringen müsste, um zu dem zu verfestigenden Volumenelement zu gelangen. Derartige Verschattungen können zu Strukturierungsfehlern führen.

In der EP 3093123 A1 ist ein Verfahren beschrieben, welches Verschattungen dadurch vermeidet, dass die einhüllenden Grenzflächen zwischen benachbarten Teilstrukturen geneigt zu der Hauptrichtung des Struktureintrags verlaufen. Die einhüllenden Grenzflächen der Teilstruktur verlaufen derart schräg zur Hauptrichtung des Struktureintrags, dass eine Verdeckung bzw. Verschattung des Struktureintrags entlang der Hauptrichtung durch bereits vorhandene Teilstrukturen vermieden wird. Es ist daher möglich, für die Teilstruktur eine vergleichsweise betragsmäßig große Tiefe entlang der Hauptrichtung zu wählen. Daher ist zur Herstellung der Gesamtstruktur eine Zerlegung in eine vergleichsweise geringe Anzahl von Teilstrukturblöcken nötig.

Ein weiteres Verfahren zum Erzeugen einer 3D-Struktur mittels Laserlithographie ist in der DE 102017110241 A1 beschrieben.

Die vorliegende Erfindung zielt darauf ab, ein verbessertes Verfahren anzugeben, mit welchem nicht nur der Verschattungsproblematik Rechnung getragen wird, sondern auch die durch das Stitching-Verfahren verursachte mechanische Bruchanfälligkeit des Bauteils verbessert wird.

Zur Lösung dieser Aufgabe sieht die Erfindung ein Verfahren gemäß Anspruch 1 vor. Das Verfahren sieht vor, dass Teilstrukturen übereinander angeordnet werden, sodass obere Teilstrukturen die Grenzfläche(n) zwischen nebeneinander angeordneten, unteren Teilstrukturen überbrücken. Dadurch, dass das Bauteil nicht nur in nebeneinander liegende, sondern auch in übereinander liegende Teilstrukturen zerlegt wird, kann die Dicke der Teilstrukturen geringer gewählt werden. Insbesondere kann die Dicke der Teilstrukturen so gering gewählt werden, dass sich keine Verschattungen ergeben.

-Erfindungsgemäß ist hierbei vorgesehen, dass das Bauteil mehrere übereinanderliegende Lagen umfasst, die jeweils aus einer Mehrzahl von nebeneinander angeordneten Teilstrukturen gebildet werden, wobei das Bauteil lagenweise aufgebaut wird, wobei die Teilstrukturen einer oberen Lage die Grenzfläche(n) zwischen aneinandergrenzenden Teilstrukturen der unmittelbar darunter liegenden Lage überbrücken. Dabei werden zur Ausbildung einer unteren Lage zuerst mehrere Teilstrukturen nebeneinander aufgebaut, bevor unmittelbar darüber die Teilstrukturen der nächsten, oberen Lage aufgebaut werden. Dadurch werden Verschattungen wesentlich reduziert bzw. bei entsprechend dünner Ausbildung der Lagen gänzlich vermieden, weil der Schatten lediglich durch die Höhe einer Lage erzeugt wird. Die Erfindung beschreitet somit einen anderen Lösungsweg als die EP 3093123 A1, wo das Bauteil lediglich aus nebeneinander angeordneten Teilstrukturen, d.h. aus einer einzigen Lage aufgebaut wird.

Beim erfindungsgemäßen Verfahren wird somit anders als bei der Lösung gemäß der EP 3093123 A1 für jede Teilstruktur keine vergleichsweise betragsmäßig große Tiefe entlang der Hauptrichtung gewählt, sondern die Tiefe der Teilstrukturen ist auf die Dicke einer Lage begrenzt, die wiederum nicht größer als die abschattungsfreie Eindringtiefe gewählt ist.

Im Rahmen der vorliegenden Erfindung kann daher auf die Ausbildung von schräg zur Eintragsrichtung verlaufenden Grenzflächen zwischen zwei aneinandergrenzenden Teilstrukturen verzichtet werden, wodurch der Steuerungsaufwand für die Strukturierungseinrichtung reduziert wird. Vielmehr verlaufen die Grenzflächen bevorzugt parallel zur Eintragsrichtung.

Es ist aber auch denkbar, dass im Rahmen der Erfindung so wie bei der Lösung gemäß der EP 3093123 A1 zwischen zwei aneinandergrenzenden Teilstrukturen schräg zur Eintragsrichtung verlaufende Grenzflächen ausgebildet werden.

Der lagenweise Aufbau des Bauteils ermöglicht es weiters die mechanische Stabilität dadurch zu verbessern, dass die Teilstrukturen einer Lage die Grenzfläche(n) zwischen aneinandergrenzenden Teilstrukturen der unmittelbar darunter liegenden Lage überbrücken. Dadurch entsteht ein Versatz zwischen den Teilstrukturen der einzelnen Lage, ähnlich wie der Versatz von Mauersteinen in einem Mauerwerksverband. Auf Grund des Versatzes werden die durch die Stoßstellen bzw. Grenzflächen zwischen zwei aneinander angrenzenden Teilstrukturen einer Lage auftretenden Schwachstellen kompensiert und insbesondere das Ausbreiten von Rissen entlang der Grenzflächen im Bauteil verhindert.

Unter einer Teilstruktur wird im Rahmen der Erfindung ein Bereich des herzustellenden Körpers verstanden, der dem Schreibbereich der Bestrahlungseinrichtung entspricht und dessen in Richtung der Eintragsrichtung gemessene Dicke im Fall des lagenweisen Aufbaus der Dicke einer Lage entspricht. Um eine Mehrzahl von Teilstrukturen auszubilden, ist bevorzugt vorgesehen, dass der Schreibbereich der Bestrahlungseinrichtung durch Veränderung der Relativposition der Bestrahlungseinrichtung relativ zum Material quer zur Eintragsrichtung der Bestrahlungseinrichtung verschoben wird, um nach dem Aufbau einer Teilstruktur eine nächste Teilstruktur aufzubauen. Hierbei kann entweder die Bestrahlungseinrichtung relativ zum ortsfesten Material verschoben werden oder es kann das Material bzw. das das Material aufnehmende Behältnis relativ zur ortsfesten Bestrahlungseinrichtung verschoben werden.

Wenn im Rahmen der Erfindung Teilstrukturen angesprochen werden, die nebeneinander liegen, so bedeutet dies, dass der Schreibbereich der Bestrahlungseinrichtung wie oben beschrieben quer zur Eintragsrichtung verschoben wird, um zuerst die eine und dann die andere der nebeneinander liegenden Teilstrukturen herzustellen. Nebeneinander liegende Teilstrukturen sind somit Teilstrukturen, die quer zur Eintragsrichtung der Bestrahlungseinrichtung unmittelbar aneinander anschließen.

Bevorzugt ist vorgesehen, dass die Grenzfläche zwischen übereinander liegenden Lagen durchgehend eben ausgebildet ist. Die eine Lage ausbildenden, aneinander grenzenden Teilstrukturen weisen somit die gleiche Dicke auf, sodass sich eine Lage einheitlicher Dicke ergibt. Die Lagen erstrecken sich hierbei quer zur Eintragsrichtung.

Alternativ kann die Grenzfläche zwischen übereinander liegenden Teilstrukturen aber auch gestuft ausgebildet sein. Insbesondere ist es vorteilhaft, wenn eine obere Teilstruktur an ihrer Unterseite eine Oberfläche aufweist, die an der Grenzfläche zwischen zwei unteren Teilstrukturen eine Stufe aufweist. Weiters ist es vorteilhaft, wenn eine untere Teilstruktur an ihrer Oberseite eine Oberfläche aufweist, die an der Grenzfläche zwischen zwei oberen Teilstrukturen eine Stufe aufweist. Auf Grund einer solchen Stufenkonfiguration erscheint die Dicke einer benachbarten Teilstruktur um die Höhe der Stufe tiefer, sodass der Verschattungseffekt weiter verringert werden oder die Dicke der Teilstrukturen ohne Verschlechterung der Verschattungsbedingungen um die Höhe der Stufe erhöht werden kann.

Eine vorteilhafte Ausbildung sieht in diesem Zusammenhang vor, dass die Höhe der Stufe 10-50%, insbesondere 20-40%, der Dicke (in Höhenrichtung gemessen) der Teilstruktur gewählt wird.

Für eine zufriedenstellende mechanische Stabilität des Bauteils ist der Versatz der übereinander liegenden Teilstrukturen bevorzugt so gestaltet, dass sich eine ausreichende Überdeckung bzw. Überlappung der Teilstrukturen ergibt. Eine bevorzugte Ausbildung sieht hierbei vor, dass zwei an einer Grenzfläche aneinander grenzende untere Teilstrukturen jeweils von der diese Grenzfläche überbrückenden oberen Teilstruktur zu wenigstens 10%, bevorzugt wenigstens 30%, besonders bevorzugt wenigstens 40%, insbesondere zu 50%, überlappt werden.

Um zu vermeiden, dass eine bereits aufgebaute Teilstruktur benachbarte Bereiche einer angrenzenden Teilstruktur derselben Lage verschattet, ist bevorzugt vorgesehen, dass die Dicke der Teilstrukturen und/oder der Lagen weniger als 100µm, vorzugsweise weniger als 50µm, vorzugsweise weniger als 30µm, insbesondere weniger als 10 µm beträgt. Insbesondere beträgt die Dicke der Teilstrukturen und/oder der Lagen bei einer numerischen Apertur des Bestrahlungssystems von 1,4 höchstens 10 µm, bei einer numerischen Apertur des Bestrahlungssystems von 0,8 höchstens 30 µm beträgt und bei einer numerischen Apertur des Bestrahlungssystems von 0,4 höchstens 50 µm.

Die einzelnen Teilstrukturen können schichtweise aufgebaut werden, d.h. aus mehreren Schichten gefertigt werden.

Eine besonders bevorzugte Verfahrensweise ergibt sich, wenn das Material auf einem Materialträger, wie z.B. in einer Wanne, vorliegt, und die Bestrahlung des Materials von unten durch den für die Strahlung zumindest bereichsweise durchlässigen Materialträger erfolgt. Hierbei kann eine Bauplattform in Abstand vom Materialträger positioniert und das Bauteil durch Verfestigen von zwischen der Bauplattform und dem Materialträger befindlichem Material auf der Bauplattform aufgebaut werden. Alternativ ist es aber auch möglich, die Bestrahlung des Materials von oben vorzunehmen.

Die Strukturierung eines geeigneten Materials mittels Multiphotonenabsorption bietet den Vorteil einer überaus hohen Strukturauflösung, wobei Volumenelemente mit minimalen Strukturgrößen von bis zu 50nm x 50nm x 50nm erzielbar sind. Bedingt durch das kleine Fokuspunktvolumen ist der Durchsatz eines solchen Verfahrens allerdings sehr gering, da z.B. für ein Volumen von lmm³ insgesamt mehr als 10⁹ Punkte belichtet werden müssen. Dies führt zu sehr langen Bauzeiten, was der Hauptgrund für den geringen industriellen Einsatz von MultiphotonenabsorptionsVerfahren ist.

Um den Bauteiledurchsatz zu erhöhen ohne die Möglichkeit einer hohen Strukturauflösung zu verlieren, sieht eine bevorzugte Weiterbildung der Erfindung vor, dass das Volumen des Fokuspunkts während des Aufbaus des Bauteils zumindest einmal variiert wird, sodass das Bauteil aus verfestigten Volumenelementen unterschiedlichen Volumens aufgebaut wird.

Durch das variable Volumen des Fokuspunktes sind (bei kleinem Fokuspunktvolumen) hohe Auflösungen möglich. Gleichzeitig ist (bei großem Fokuspunktvolumen) eine hohe Schreibgeschwindigkeit (gemessen in mm³/h) erzielbar. Durch das Variieren des Fokuspunktvolumens kann also eine hohe Auflösung mit großem Durchsatz kombiniert werden. Die Variation des Fokuspunktvolumens kann dabei zum Beispiel so genutzt werden, dass im Inneren des aufzubauenden Bauteils ein großes Fokuspunktvolumen verwendet wird, um den Durchsatz zu erhöhen, und an der Oberfläche des Bauteils ein kleineres Fokuspunktvolumen zur Anwendung kommt, um die Bauteiloberfläche mit hoher Auflösung auszubilden. Eine Vergrößerung des Fokuspunktvolumens ermöglicht einen höheren Strukturierungsdurchsatz, da das in einem Belichtungsvorgang verfestigte Materialvolumen vergrößert wird. Um bei hohem Durchsatz eine hohe Auflösung beizubehalten, können kleine Fokuspunktvolumina für feinere Strukturen und Oberflächen, und größere Fokuspunktvolumina für grobe Strukturen und/oder zum Füllen von Innenräumen verwendet werden.

Bei einer bevorzugten Verfahrensweise erfolgt die Variation des Fokusvolumens derart, dass das Volumenverhältnis zwischen dem größten Fokuspunktvolumen während der Fertigung eines Bauteils und dem kleinsten Fokuspunktvolumen mindestens 2, bevorzugt mindestens 5 beträgt.

Das Prinzip der Multiphotonenabsorption wird im Rahmen der Erfindung genutzt, um im photosensitiven Materialbad einen photochemischen Vorgang zu initiieren. Multiphotonenabsorptionsverfahren umfassen beispielsweise auch Verfahren der 2-Photonenabsorption. Als Folge der photochemischen Reaktion kommt es zur Veränderung des Materials in mindestens einen anderen Zustand, wobei es typischerweise zu einer Photopolymerisation kommt. Das Prinzip der Multiphotonenabsorption beruht darauf, dass der genannte photochemische Vorgang nur in jenen Bereichen des Strahlengangs stattfindet, in denen eine für die Multiphotonenabsorption ausreichende Photonendichte vorliegt. Die höchste Photonendichte tritt im Brennpunkt des optischen Abbildungssystems auf, sodass die Multiphotonenabsorption mit ausreichender Wahrscheinlichkeit nur im Fokuspunkt auftritt. Außerhalb des Brennpunktes ist die Photonendichte geringer, sodass die Wahrscheinlichkeit der Multiphotonenabsorption außerhalb des Brennpunktes zu gering ist, um eine unumkehrbare Veränderung des Materials durch eine photochemische Reaktion zu bewirken. Die elektromagnetische Strahlung kann in der verwendeten Wellenlänge weitestgehend ungehindert das Material passieren und nur im Fokuspunkt kommt es zu einer Interaktion zwischen photosensitivem Material und elektromagnetischer Strahlung. Das Prinzip der Multiphotonenabsorption ist beispielsweise in Zipfel et al, "Nonlinear magic: multiphoton microscopy in the biosciences", NATURE BIOTECHNOLOGY VOLUME 21 NUMBER 11 NOVEMBER 2003, beschrieben.

Als Quelle für die elektromagnetische Strahlung kann es sich vorzugsweise um einen kollimierten Laserstrahl handeln. Der Laser kann sowohl eine oder mehrere, feste oder variable Wellenlängen emittieren. Insbesondere handelt es sich um einen kontinuierlichen oder gepulsten Laser mit Pulslängen im Nanosekunden-, Pikosekunden- oder Femtosekunden-Bereich. Ein gepulster Femtosekundenlaser bietet dabei den Vorteil, dass eine geringere mittlere Leistung für die Multiphotonenabsorption benötigt wird.

Unter photosensitivem Material wird jedes unter Baubedingungen fließfähige Material verstanden, das durch Multiphotonenabsorption im Fokuspunktvolumen in einen zweiten Zustand übergeht - beispielsweise durch Polymerisation. Die Materialveränderung muss sich dabei auf das Fokuspunktvolumen und dessen direkte Umgebung begrenzen. Die Veränderung der Substanzeigenschaften kann dauerhaft sein und beispielsweise in einer Veränderung von einem flüssigen in einen festen Zustand bestehen, kann jedoch auch nur vorübergehend sein. Auch eine dauerhafte Veränderung kann im Übrigen reversibel oder nicht reversibel sein. Die Änderung der Materialeigenschaften muss nicht zwingend vollständig von einem in den anderen Zustand übergehen, sondern kann auch als Mischform beider Zustände vorliegen.

Die Leistung der elektromagnetischen Strahlung und die Belichtungsdauer beeinflussen die Qualität des erzeugten Bauteils. Durch Anpassung der Strahlungsleistung und/oder der Belichtungsdauer kann das Volumen des Fokuspunktes in einem engen Bereich variiert werden. Bei zu hohen Strahlungsleistungen treten zusätzliche Prozesse auf, die zur Beschädigung des Bauteils führen können. Ist die Strahlungsleistung zu gering, kann sich keine dauerhafte Materialeigenschaftsänderung einstellen. Für jedes photosensitive Material gibt es daher typische Bauprozessparameter die mit guten Bauteileigenschaften verbunden sind.

Die oben beschriebene Variation des Fokuspunktvolumens beruht hierbei jedoch nicht auf einer Änderung der Intensität der verwendeten elektromagnetischen Strahlung. Vielmehr wird mit der für den Bauprozess gewählten (optimalen) Strahlungsintensität gearbeitet, die während des Bauteilaufbaus unverändert gelassen wird. Das Verfahren wird daher bevorzugt so durchgeführt, dass die Änderung des Fokuspunktvolumens bei gleichbleibender Strahlungsintensität vorgenommen wird, wobei die verwendete durchschnittliche Leistung der elektromagnetischen Strahlung dementsprechend angepasst wird.

Als Fokuspunktvolumen wird daher jenes Volumen eines belichteten Punktes nach dem Aufbereitungsschritt bei den typischen Bauprozessparametern verstanden. Unter der oben beschriebenen Änderung des Fokuspunktvolumens wird eine Veränderung der räumlichen Intensitätsverteilung im Fokuspunkt verstanden. Hierbei kann die räumliche Intensitätsverteilung des Fokuspunktes sowohl in eine oder mehrere Richtungen verändert werden. So kann zum Beispiel durch Reduktion der effektiven numerischen Apertur des optischen Abbildungssystems die Intensitätsverteilung in alle drei Raumrichtungen vergrößert werden. Bei der Verwendung eines diffraktiven optischen Elementes kann der Fokus in eine Linie oder Fläche verändert, oder die Anzahl der Fokuspunkte erhöht werden.

Eine Reihe von apparativen Möglichkeiten zur Veränderung des Fokuspunktvolumens ist in der WO 2018/006108 A1 beschrieben.

Bevorzugt ist vorgesehen, dass die Änderung des Fokuspunktvolumens in wenigstens einer, bevorzugt zwei, insbesondere in drei, senkrecht zueinander stehenden Raumrichtungen erfolgt.

Insbesondere kann die elektromagnetische Strahlung mittels einer Ablenkeinheit abgelenkt werden, um den Fokuspunkt in einer im Wesentlichen senkrecht zur Eintragsrichtung verlaufenden Ebene innerhalb des Schreibbereichs zu verstellen.

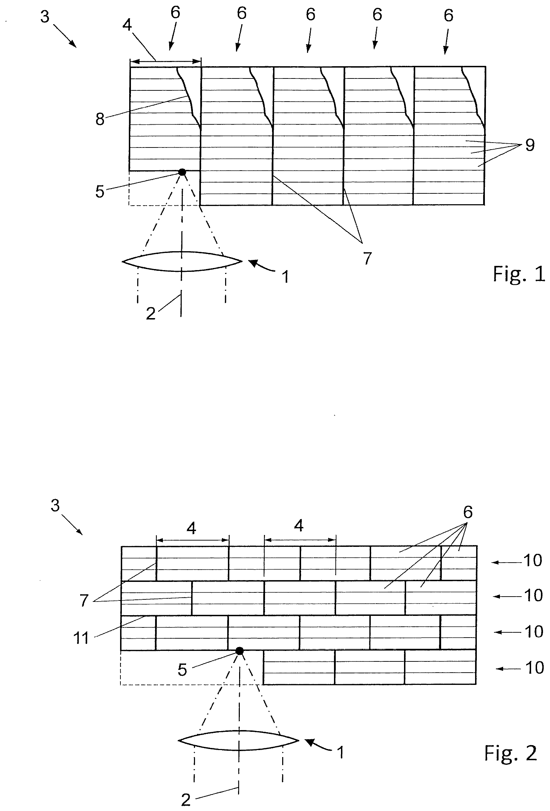

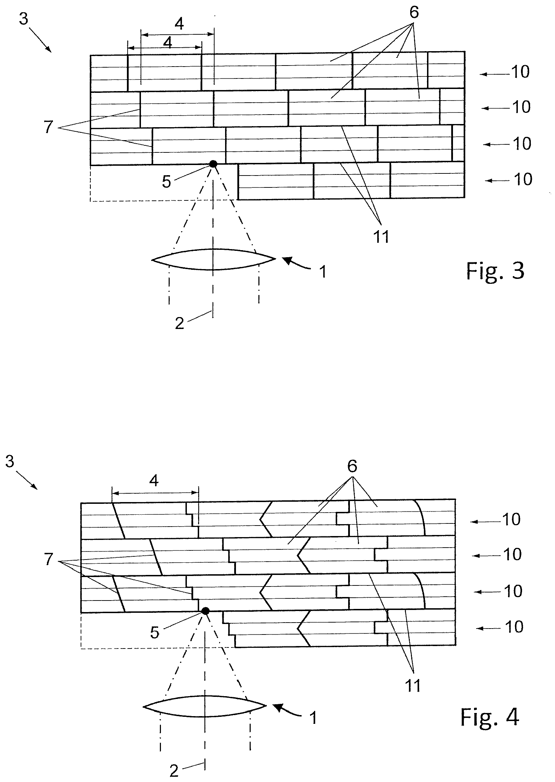

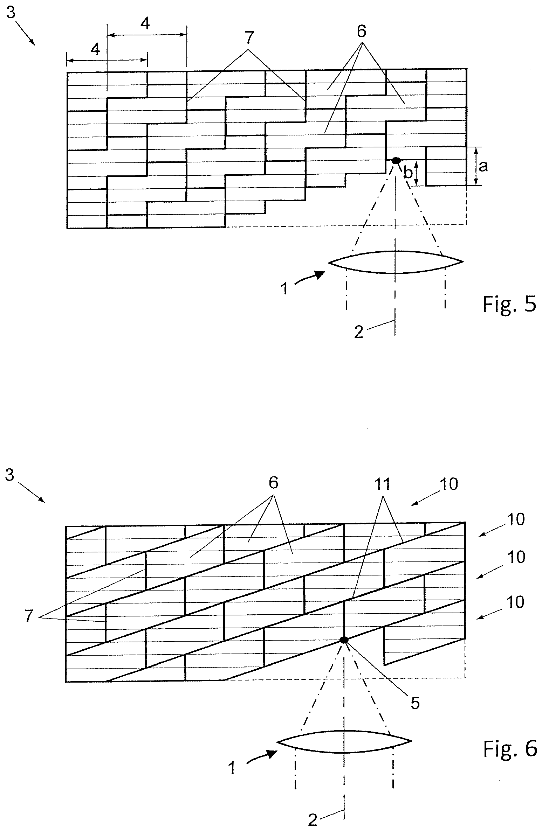

Die Erfindung wird nachfolgend anhand von in der Zeichnung schematisch dargestellten Ausführungsbeispielen näher erläutert. In dieser zeigen Fig. 1 eine schematische Darstellung eines herkömmlichen Verfahrens zum Aufbau eines dreidimensionalen Bauteils, Fig. 2 ein Verfahren nach der Erfindung, Fig. 3 eine abgewandelte Ausführung des Verfahrens nach Fig. 2, Fig. 4 eine weitere abgewandelte Ausführung des Verfahrens nach Fig. 2, Fig. 5 eine weitere abgewandelte Ausführung des Verfahrens nach Fig. 2, Fig. 6 eine weitere abgewandelte Ausführung des Verfahrens nach Fig. 2 und Fig. 7 und Fig. 8 weitere abgewandelte Ausführungen.

In Fig. 1 ist mit 1 schematisch eine optische Einheit 1 einer Bestrahlungseinrichtung im Querschnitt dargestellt, welche eine Eintragsrichtung 2 aufweist. Die Eintragsrichtung 2 gibt die Richtung an, in welcher die elektromagnetische Strahlung von der Bestrahlungseinrichtung auf das auszubildende Bauteil 3 in der Grundeinstellung abgegeben wird. Die Bestrahlungseinrichtung weist einen Schreibbereich mit einer Ausdehnung 4 auf, die der Breite entspricht, innerhalb welcher die abgegebene Strahlung innerhalb des Materials, welches durch die Strahlung verfestigt werden soll, auf Fokuspunkte 5 fokussiert werden kann. Um nacheinander auf verschiedene Fokuspunkte innerhalb des Schreibbereichs fokussieren zu können, umfasst die Bestrahlungseinrichtung eine nicht näher dargestellte Einheit, wie z.B. eine Ablenkeinheit. Wenn die genannte Einheit ausgebildet ist, um die Einstrahlungsrichtung zu ändern, so ist unter dem Begriff "Eintragsrichtung" die Haupteintragsrichtung der Bestrahlungseinrichtung in der Grundstellung zu verstehen.

Da die Ausdehnung 4 des Schreibbereichs nicht ausreicht, um das gesamte Bauteil zu erzeugen, wird das Bauteil aus einer Mehrzahl von nebeneinander angeordneten Teilstrukturen 6 aufgebaut. Dabei kann so vorgegangen werden, dass die Teilstruktur 6 in Höhenrichtung aus einer Mehrzahl von Schichten 9 aufgebaut wird. Zuerst wird eine erste Teilstruktur 6 ausgebildet, die innerhalb des Schreibbereichs der Bestrahlungseinrichtung liegt. Danach wird der Schreibbereich durch Verlagerung der Bestrahlungseinrichtung relativ zum Bauteil 3 oder durch Verlagerung des Bauteils 3 relativ zur Bestrahlungseinrichtung seitlich verschoben, um neben der ersten Teilstruktur 6 eine zweite Teilstruktur 6 aufzubauen. Dies wird solange wiederholt, bis aus allen Teilstrukturen das fertige Bauteil 3 zusammengesetzt wurde. Ein solcherart aufgebautes Bauteil besitzt an den Grenzflächen 7 zwischen nebeneinander angeordneten Teilstrukturen 6 mechanische Schwachstellen.

Weiters tritt bei Überschreitung einer bestimmten, in der Eintragsrichtung gemessenen Höhe einer Teilstruktur 6 eine Verschattung auf. Dies bedeutet, dass eine bereits aufgebaute Teilstruktur 6 den aus der optischen Einheit 1 kommenden, auf einen Fokuspunkt innerhalb der links daran anschließenden Teilstruktur gerichteten Strahl abschatten kann, wie dies anhand der Linie 8 schematisch dargestellt ist. In dem durch die Linie 8 begrenzten Bereich kommt es daher zu Strukturierungsfehlern, die es zu vermeiden gilt.

In Fig. 2 ist ersichtlich, dass das Bauteil 3 gemäß dem erfindungsgemäßen Verfahren wieder aus einer Mehrzahl von Teilstrukturen 6 aufgebaut wird, wobei die Teilstrukturen 6 nun nicht nur nebeneinander, sondern auch übereinander angeordnet sind. Bei der Ausbildung gemäß Fig. 2 sind die Teilstrukturen 6 hierzu in übereinander angeordneten Lagen 10 angeordnet, sodass die Grenzfläche 11 zwischen übereinander liegenden Lagen 10 durchgehend eben ausgebildet ist. Dadurch, dass das Bauteil 3 nicht nur in seitlicher Richtung, sondern auch in Höhenrichtung aus einer Mehrzahl von Teilstrukturen 6 zusammengesetzt wird, kann jede einzelne Teilstruktur 6 mit einer im Hinblick auf die Vermeidung von Verschattungen verringerten Höhe ausgebildet werden. Weiters wird dadurch die Möglichkeit eröffnet, die Teilstrukturen 6 der einzelnen Lagen 10 seitlich gegeneinander zu versetzen, sodass obere Teilstrukturen 6 die Grenzflächen 7 zwischen nebeneinander angeordneten, direkt darunter liegenden Teilstrukturen 6 überbrücken. Bei der Ausbildung gemäß Fig. 2 beträgt der seitliche Versatz die Hälfte der Breite der einzelnen Teilstrukturen 6, sodass zwei an einer Grenzfläche 7 aneinander grenzende untere Teilstrukturen 6 jeweils von der diese Grenzfläche 7 überbrückenden oberen Teilstruktur 6 zu 50%, überlappt werden.

Bei der abgewandelten Ausbildung gemäß Fig. 3 beträgt der Versatz lediglich 10%.

Während die Grenzflächen 7 zwischen nebeneinander angeordneten Teilstrukturen 6 parallel zur Eintragsrichtung 2 verlaufen, zeigt Fig. 4 verschiedene alternative Möglichkeiten, nämlich schräg zur Eintragsrichtung 2 verlaufende, gekrümmte und gestufte Grenzflächen 7. Dadurch kann Verschattungen zusätzlich vorgebeugt werden.

In Fig. 5 ist eine weitere abgewandelte Ausbildung dargestellt, bei der die übereinander liegenden Teilstrukturen 6 nicht lagenartig angeordnet sind, sondern gemäß einer gestuften Anordnung. Die Teilstrukturen 6 weisen an ihrer Unterseite sowie an ihrer Oberseite jeweils eine Oberfläche auf, die an der Stelle, an der zwischen darunter oder zwischen darüber liegenden Teilstrukturen eine Grenzfläche 7 vorgesehen ist, eine Stufe hat. Auf Grund einer solchen Stufenkonfiguration ist der im Hinblick auf eine Verschattung relevante, vorstehende Anteil b der Höhe a einer Teilstruktur 6 geringer als bei einer Ausbildung gemäß Fig. 2, sodass Verschattungen noch wirksamer vermieden werden oder die Höhe der Teilstrukturen ohne Erhöhung des Verschattungsrisikos vergrößert werden kann.

In Fig. 6 ist eine alternative Anordnung der Teilstrukturen 6 dargestellt, wobei die Grenzflächen 11 zwischen übereinander liegenden Teilstrukturen 6 bzw. zwischen den Lagen 10 nun nicht im rechten Winkel zur Eintragsrichtung 2, sondern in einem Winkel von max. 45°, bevorzugt max. 30° zur Eintragsrichtung 2 schräg verlaufen.

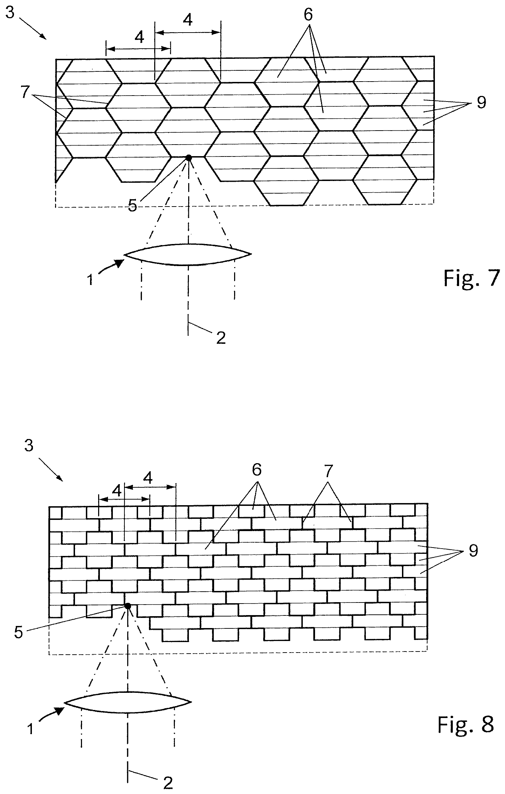

Fig. 7 zeigt eine weitere Möglichkeit der erfindungsgemäßen Anordnung der Teilstrukturen 6. Die Teilstrukturen 6 weisen hier einen hexagonalen Querschnitt auf, sodass sich eine wabenförmige Anordnung aus nebeneinander und übereinander angeordneten Teilstrukturen ergibt.

Bei der Ausbildung gemäß Fig. 8 sind die Teilstrukturen 6 in der Form von Kreuzen ausgebildet.

Anzumerken ist, dass die Teilstrukturen 6 wie in den Fig. 1 bis 8 gezeigt lediglich durch Umrandungslinien dargestellt sind, die denjenigen räumlichen Bereich angeben, in dem die Verfestigung der Volumenelemente innerhalb der jeweiligen Teilstruktur stattfindet, ohne dass eine bestimmte Strukturierung dargestellt ist. Es versteht sich, dass im Rahmen der Herstellung eines Bauteils der jeweils gewünschten Geometrie nicht alle Volumenelemente innerhalb einer Teilstruktur verfestigt werden müssen, sondern dass innerhalb der Teilstrukturen Volumenbereiche freibleiben können.

## Patentansprüche

1. Verfahren zur lithographiebasierten generativen Fertigung eines dreidimensionalen Bauteils (3), bei dem von einer Bestrahlungseinrichtung ausgesendete elektromagnetische Strahlung nacheinander auf Fokuspunkte (5) innerhalb eines Materials fokussiert wird, wodurch jeweils ein am Fokuspunkt befindliches Volumenelement des Materials mittels Multiphotonenabsorption verfestigt wird, wobei in einem Schreibbereich der Bestrahlungseinrichtung aus den Volumenelementen jeweils eine Teilstruktur (6) aufgebaut wird und eine Mehrzahl von Teilstrukturen nebeneinander angeordnet wird, wobei das Bauteil mehrere übereinanderliegende Lagen (10) umfasst, die jeweils aus einer Mehrzahl von nebeneinander angeordneten Teilstrukturen gebildet werden, **dadurch gekennzeichnet, dass** das Bauteil lagenweise aufgebaut wird, indem zur Ausbildung einer unteren Lage zuerst mehrere Teilstrukturen nebeneinander aufgebaut werden, wonach unmittelbar darüber die Teilstrukturen einer oberen Lage aufgebaut werden, welche die Grenzfläche(n) (7) zwischen aneinandergrenzenden Teilstrukturen der unmittelbar darunter liegenden Lage überbrücken.

2. Verfahren nach Anspruch 1, **dadurch gekennzeichnet, dass** die Grenzfläche (11) zwischen übereinander liegenden Lagen durchgehend eben ausgebildet ist.

3. Verfahren nach Anspruch 1, **dadurch gekennzeichnet, dass** die Grenzfläche zwischen übereinander liegenden Teilstrukturen gestuft ausgebildet ist.

4. Verfahren nach einem der Ansprüche 1 bis 3, **dadurch gekennzeichnet, dass** der Schreibbereich der Bestrahlungseinrichtung durch Veränderung der Relativposition der Bestrahlungseinrichtung relativ zum Material quer zur Eintragsrichtung der Bestrahlungseinrichtung verschoben wird, um nach dem Aufbau einer Teilstruktur eine nächste Teilstruktur aufzubauen.

5. Verfahren nach einem der Ansprüche 1 bis 4, **dadurch gekennzeichnet, dass** zwei an einer Grenzfläche aneinander grenzende untere Teilstrukturen jeweils von der diese Grenzfläche überbrückenden oberen Teilstruktur zu wenigstens 10%, bevorzugt wenigstens 30%, besonders bevorzugt wenigstens 40%, insbesondere zu 50%, überlappt werden.

6. Verfahren nach einem der Ansprüche 1 bis 5, **dadurch gekennzeichnet, dass** die Dicke der Teilstrukturen und/oder der Lagen weniger als 100µm, vorzugsweise weniger als 50µm, vorzugsweise weniger als 30µm, insbesondere weniger als 10 µm beträgt.

7. Verfahren nach einem der Ansprüche 1 bis 6, **dadurch gekennzeichnet, dass** das Material auf einem Materialträger, wie z.B. in einer Wanne, vorliegt, und die Bestrahlung des Materials von unten durch den für die Strahlung zumindest bereichsweise durchlässigen Materialträger erfolgt.

8. Verfahren nach Anspruch 7, **dadurch gekennzeichnet, dass** eine Bauplattform in Abstand vom Materialträger positioniert wird und das Bauteil durch Verfestigen von zwischen der Bauplattform und dem Materialträger befindlichem Material auf der Bauplattform aufgebaut wird.

9. Verfahren nach einem der Ansprüche 1 bis 8, **dadurch gekennzeichnet, dass** das Volumen des Fokuspunkts während des Aufbaus des Bauteils zumindest einmal variiert wird, sodass das Bauteil aus verfestigten Volumenelementen unterschiedlichen Volumens aufgebaut wird.

10. Verfahren nach Anspruch 9, **dadurch gekennzeichnet, dass** die Änderung des Fokuspunktvolumens in wenigstens einer, bevorzugt zwei, insbesondere in drei, senkrecht zueinander stehenden Raumrichtungen erfolgt.

11. Verfahren nach einem der Ansprüche 1 bis 10, **dadurch gekennzeichnet, dass** die elektromagnetische Strahlung mittels einer Ablenkeinheit abgelenkt wird, um den Fokuspunkt in einer im Wesentlichen senkrecht zur Eintragsrichtung verlaufenden Ebene innerhalb des Schreibbereichs zu verstellen.

## Claims

1. Method for the lithography-based generative production of a three-dimensional component (3), in which electromagnetic radiation emitted by an irradiation device is successively focused on focal points (5) within a material, wherein in each case a volume element of the material located at the focal point is solidified by means of multiphoton absorption, wherein a substructure (6) is each built up from the volume elements in a writing area of the irradiation device, and a plurality of substructures are arranged next to one another, wherein the component comprises several superimposed layers (10), which are each formed from a plurality of substructures arranged next to one another, **characterized in that** the component is built up in layers, by first building up a plurality of substructures next to one another to form a lower layer, after which immediately above the substructures of an upper layer are built up, which bridge the interface(s) (7) between adjacent substructures of the layer arranged immediately below.

2. Method according to claim 1, **characterized in that** the interface (11) between layers lying one on top of the other layer is flat throughout.

3. Method according to claim 1, **characterized in that** the interface between substructures lying one above the other is stepped.

4. Method according to any one of claims 1 to 3, **characterized in that** the writing area of the irradiation device is displaced by changing the relative position of the irradiation device relative to the material transversely to the entry direction of the irradiation device in order to build up, after a substructure has been built up, a next adjacent substructure.

5. Method according to any one of claims 1 to 4, **characterized in that** two lower substructures (6) adjoining one another at an interface are each overlapped by at least 10%, preferably at least 30%, particularly preferably at least 40%, in particular 50%, by the upper substructure that bridges this interface.

6. Method according to any one of claims 1 to 5, **characterized in that** the thickness of the substructures and/or of the layers is less than 100 µm, preferably less than 50 µm, preferably less than 30 µm, in particular less than 10 µm.

7. Method according to any one of claims 1 to 6, **characterized in that** the material is present on a material carrier, such as in a vat, and the material is irradiated from below through the material carrier which is at least partially transparent to the radiation.

8. Method according to claim 7, **characterized in that** a building platform is positioned at a distance from the material carrier and the component is built up on the building platform by solidifying material located between the building platform and the material carrier.

9. Method according to any one of claims 1 to 8, **characterized in that** the volume of the focal point is varied at least once during the construction of the component, so that the component is built up from solidified volume elements of different volumes.

10. Method according to claim 9, **characterized in that** the change in the focal point volume takes place in at least one, preferably two, in particular in three spatial directions perpendicular to one another.

11. Method according to any one of claims 1 to 10, **characterized in that** the electromagnetic radiation is deflected by means of a deflection unit in order to adjust the focal point within the writing area in a plane that is essentially perpendicular to the entry direction.

## Revendications

1. Procédé de production générative basée sur la lithographie d'un composant tridimensionnel (3), dans lequel un rayonnement électromagnétique émis par un dispositif d'irradiation est successivement focalisé sur des points focaux (5) à l'intérieur d'un matériau, à la suite de quoi un élément de volume du le matériau situé au point focal est solidifié par absorption multiphotonique, dans lequel une structure partielle (6) est constituée à partir des éléments volumiques dans une zone d'écriture du dispositif d'irradiation et une pluralité de structures partielles sont disposées les unes à côté des autres, le composant comprenant une pluralité de couches superposées (10) qui sont formées à chaque fois à partir d'une pluralité de structures partielles agencées les unes à côté des autres, **caractérisé en ce que** le composant est construit en couches en construisant d'abord une pluralité de structures partielles les unes à côté des autres pour former une couche inférieure, après quoi les structures partielles d'une couche supérieure sont construites immédiatement au-dessus de celles-ci, franchissant l'interface/les interfaces entre les structures partielles adjacentes de la couche immédiatement inférieure.

2. Procédé selon la revendication 1, **caractérisé en ce que** l'interface (11) entre des couches superposées est continuellement plane.

3. Procédé selon la revendication 1, **caractérisé en ce que** l'interface entre des structures partielles superposées est réalisée en escalier.

4. Procédé selon l'une des revendications 1 bis 3, **caractérisé en ce que** la zone d'écriture du dispositif d'irradiation est décalée transversalement à la direction d'entrée du dispositif d'irradiation en changeant la position relative du dispositif d'irradiation par rapport au matériau, afin de construire une structure partielle suivante après la construction d'une structure partielle.

5. Procédé selon l'une des revendications 1 bis 4, **caractérisé en ce que** deux structures partielles inférieures contiguës au niveau d'une interface sont chacune recouvertes d'au moins 10 %, de préférence d'au moins 30%, de manière particulièrement préférée d'au moins 40 %, en particulier de 50 %, par la structure partielle supérieure franchissant cette interface.

6. Procédé selon l'une des revendications 1 bis 5, **caractérisé en ce que** l'épaisseur des structures partielles et/ou des couches est inférieure à 100 µm, de préférence inférieure à 50 µm, de préférence inférieure à 30 µm, en particulier inférieure à 10 µm.

7. Procédé selon l'une des revendications 1 bis 6, **caractérisé en ce que** le matériau se trouve sur un support de matériau, tel que par exemple dans un bac, et **en ce que** l'irradiation du matériau s'effectue par le bas à travers le support de matériau, qui est au moins partiellement transparent au rayonnement.

8. Procédé selon la revendication 7, **caractérisé en ce qu'**une plate-forme de construction est positionnée à distance du support de matériau et le composant est assemblé sur la plate-forme de construction par solidification de matériau situé entre la plate-forme de construction et le support de matériau.

9. Procédé selon l'une des revendications 1 bis 8, **caractérisé en ce que** l'on fait varier au moins une fois le volume du point focal lors de la construction du composant, de sorte que le composant est constitué d'éléments volumiques solidifiés de volumes différents.

10. Procédé selon la revendication 9, **caractérisé en ce que** la modification du volume du point focal s'effectue dans au moins une, de préférence dans deux, en particulier dans trois directions spatiales perpendiculaires entre elles.

11. Procédé selon l'une des revendications 1 bis 10, **caractérisé en ce que** le rayonnement électromagnétique est dévié au moyen d'une unité de déviation pour régler le point focal dans un plan sensiblement perpendiculaire à la direction d'entrée dans la zone d'écriture.
